# FASCICULE DE BREVET EUROPEEN

(11) **EP 0 493 148 B1**
(45) Date de publication et mention de la délivrance du brevet: **05.03.1997**
(21) Numéro de dépôt: 91403188.5
(22) Date de dépôt: 26.11.1991
(51) Int. Cl.: C04B 35/80, C23C 16/36

(54) **Matériau composite à renfort fibreux réfractaire et son procédé de fabrication**
Verbundmaterial mit feuerfester Faserarmierung und sein Herstellungsverfahren
Composite material with refractory fibrous reinforcement and its process of production

(30) Priorité: 28.11.1990 FR 9014874
(43) Date de publication de la demande: 01.07.1992
(73) Titulaire: AEROSPATIALE Société Nationale Industrielle, 75781 Paris Cédex 16 (FR)
(72) Inventeur: Saugnac, Frédéric, F-33600 Pessac (FR)
(74) Mandataire: Lhoste, Catherine

(56) Documents cités:
- EP-A- 0 380 375
- DE-A- 2 505 009

## Description

La présente invention se rapporte à des matériaux composites comportant des fibres réfractaires de renfort noyées dans une matrice et à leur procédé de fabrication.

Par fibres réfractaires, on entend toute fibre susceptible de supporter sans modification ou dégradation fondamentale une température d'au moins 700°C sous une atmosphère non réactive avec la fibre. Ces fibres sont par exemple en carbone, carbure ou nitrure de silicium, carbonitrure de silicium (SiCN), alumine, silice, zircone, les aluminosilicates tels que l'aluminosilicate de bore (BAS), mullite (2SiO₂-2Al₂O₃), etc.

Le renfort fibreux assure la résistance et la rigidité des pièces en matériau composite et la matrice assure la liaison entre les fibres de renfort ainsi que le transfert des efforts.

La matrice peut être une matrice organique ou une matrice inorganique. Comme matrice inorganique, on peut citer les matrices céramiques, vitrocéramiques, verre (borosilicate). Une matrice organique peut être utilisée dans le cadre de l'augmentation de la section de capture de neutrons d'un matériau composite.

Par matrice céramique, on entend toutes compositions réfractaires du type oxyde, carbure, borure et nitrure ainsi que des matrices de carbone. Comme matrice céramique, on peut citer des matrices de nitrure d'aluminium, de carbure ou de nitrure de silicium, de carbonitrure de silicium ou de bore, des matrices d'oxyde tel que ZrO₂-TiO₂, ZrO₂-SiO₂, Al₂O₃, mullite.

Par vitrocéramique, on entend toutes compositions réfractaires du type silicate métallique comme par exemple les aluminosilicates de lithium (LAS), les aluminosilicates de lithium et de magnésium (MLAS).

Ces matériaux composites peuvent être utilisés dans de nombreux secteurs industriels et notamment dans les domaines spatial, aéronautique, automobile, nautique, dans le domaine des sports de compétition et de façon générale pour la réalisation de pièces mécaniques légères à haute tenue mécanique.

Lorsque les matériaux composites sont du type céramique-céramique, ils sont utilisables en particulier dans des applications exigeant des propriétés thermomécaniques élevées.

L'association de fibres et de matrices de nature physico-chimique différente conduit à des problèmes d'interface entre les fibres et la matrice tels que la mouillabilité, l'adhérence, l'oxydation.

Par exemple, une matrice céramique a un faible allongement à la rupture, une mauvaise résistance en traction et une grande sensibilité à l'entaille. Dans ce cas, l'obtention d'un matériau peu sensible aux chocs et à la propagation des fissures initiées par le moindre défaut dans la matrice requiert une liaison fibres-matrice faible.

En effet, la fissuration provenant de la matrice est alors arrêtée et/ou déviée à l'interface fibres-matrice, ce qui confère au matériau une rupture non fragile.

Mais alors, le matériau n'est pas résistant par constitution puisqu'il est connu que l'obtention de matériaux composites aux propriétés mécaniques élevées nécessite une forte liaison entre la structure fibreuse et la matrice.

Pour résoudre les différents problèmes d'interface, on utilise en général un matériau d'interphase organique ou inorganique déposé sur les fibres et/ou dans la matrice.

Ce matériau d'interphase présente un allongement à la rupture supérieur à celui de la matrice afin d'améliorer les propriétés mécaniques des matériaux composites.

Par ailleurs, cette couche d'interphase peut jouer le rôle de protection chimique contre l'oxydation ou l'agressivité de certaines matrices vis-à-vis des fibres.

Les matériaux d'interphase des composites céramique-céramique actuellement utilisés sont le pyrocarbone laminaire ou le nitrure de bore (BN) qui sont tous deux des matériaux anisotropes de structure cristallographique lamellaire ou en feuillets faiblement liés entre eux. Voir à cet effet le document FR-A-2 567 874.

L'utilisation de carbone comme matériau d'interphase limite considérablement le domaine d'application des matériaux composites correspondant du fait de l'oxydation à basse température (405°C) du carbone et de la transformation de ce dernier en gaz tendant à s'échapper du matériau composite. Les matériaux composites à matériau d'interphase en carbone ne peuvent donc pas être utilisés pour des applications à haute température et de longue durée.

Le nitrure de bore en feuillets présente une meilleure résistance à l'oxydation que le carbone. Il ne commence à s'oxyder qu'à partir de 800°C pour donner naissance à une phase condensée solide (B₂O₃) qui reste dans le matériau composite et atténue la vitesse d'oxydation du nitrure de bore sous-jacent.

Il est aussi connu d'utiliser des matériaux d'interphase multicouches comme décrit dans le document FR-A-2 641 776. Ces matériaux d'interphase multiple comportent une couche de pyrocarbone ou de nitrure de bore cristallin, associée à une interphase de contrôle en matériau amorphe définissant une zone de cheminement préférentielle des fissures propagées dans la matrice.

Ces matériaux d'interphase multicouches compliquent quelque peu le procédé de fabrication des matériaux composites (changement de réactifs, des conditions de dépôt), la durée de fabrication de ces matériaux et par conséquent le coût de fabrication de ces matériaux.

Dans un matériau composite à matrice métallique, il est connu, par exemple du document FR-A-2 273 080 un composé contenant du carbone, de l'azote et du bore pour enrober des fibres de tungstène en vue d'améliorer la mouillabilité de ces fibres par le liant métallique, ce dernier ayant tendance à se mettre en gouttes et à empêcher de densifier correctement la préforme fibreuse.

Dans l'invention, on s'intéresse à l'amélioration des propriétés mécaniques des matériaux composites à fibres réfractaires par réalisation d'une liaison fibres-matrice faible. Ces matériaux composites sont en particulier des matériaux à matrice non métallique (céramique, vitrocéramique ou verre).

L'invention a pour objet un matériau composite à renfort fibreux réfractaire comportant un nouveau matériau d'interphase pour réaliser une liaison fibres-matrice faible permettant notamment de remédier aux inconvénients mentionnés ci-dessus. En particulier, ce nouveau matériau d'interphase présente une résistance à l'oxydation supérieure à celle du carbone, voire même supérieure à celle du nitrure de bore. En outre, la fabrication du matériau composite de l'invention est beaucoup plus simple que celle des matériaux composites à matériau d'interphase multiple.

L'invention repose sur la mise en oeuvre d'un nouveau matériau réfractaire à base de bore, d'azote et de carbone qui peut être déposé sous forme de couche mince sur les fibres du matériau composite.

Ce matériau réfractaire constitue une véritable solution solide carbone-bore-azote, appelée carbonitrure de bore.

Cette solution solide peut avoir des compositions variables, allant du carbone presque pur au nitrure de bore presque pur. La composition est choisie selon la nature des fibres et de la matrice utilisées et selon l'application envisagée.

En particulier, la composition du carbonitrure de bore peut être adaptée de sorte que son coefficient de dilatation soit le plus proche possible de celui de la matrice limitant ainsi les risques de fissures de cette dernière. Selon sa structure et sa composition, le coefficient de dilatation du carbonitrure de bore varie de 1.10⁻⁶/K à 36.10⁻⁶/K.

De façon plus précise, l'invention a pour objet un matériau composite à renfort fibreux, comportant des fibres réfractaires noyées dans une matrice non métallique, et un matériau d'interphase interposé entre les fibres et la matrice, caractérisé en ce que le matériau d'interphase est du carbure ou du carbonitrure de bore à structure lamellaire et/ou amorphe contenant en % d'atomes, de 0 à 98% d'azote, de 1 à 99% de carbone et de 1 à 99% de bore.

En outre l'invention a pour objet un matériau composite tel que revendiqué dans la revendication 7.

Selon l'invention, le carbonitrure de bore d'interphase présente une composition homogène sur toute son épaisseur ou bien une composition non homogène.

Le carbonitrure de bore sera noté ci-après CBN.

La structure du CBN est fonction de sa composition. Ainsi, il est possible d'adapter la structure du matériau d'interphase en fonction de la nature des fibres et de la matrice ainsi que de l'application envisagée. En particulier, le CBN riche en BN a une structure amorphe alors que le CBN riche en C et en B et faible en N, voire même exempt d'azote, présente une structure cristalline en feuillets ou lamellaire comme le pyrocarbone et le nitrure de bore. Entre l'état amorphe et l'état cristallin, le CBN présente une structure intermédiaire qui s'organise de plus en plus lorsque la quantité de C croît.

La structure cristalline apparaît pour une concentration en carbone supérieure à 60% en atomes et un rapport B/N supérieur à 1,87 et la structure amorphe apparaît pour une concentration en carbone inférieure à 42% en atomes et un rapport B/N inférieur à 1,45.

Le CBN, en plus des avantages mentionnés ci-dessus, présente un coefficient de dilatation inférieur à celui du BN, ce qui fait que le CBN a moins tendance à se délaminer que le BN conduisant ainsi à une meilleure cohésion du matériau composite.

Par ailleurs, le CBN cristallin s'oxyde à 820°C en formant du B₂O₃, et donc une couche d'autoprotection. Le BN cristallisé quant à lui, s'oxyde à 800°C pour former aussi une couche de B₂O₃ mais avec une vitesse d'oxydation plus grande que celle du CBN.

En outre, le CBN cristallin présente une stabilité thermique jusqu'à 2000°C, sous une atmosphère non réactive.

Le carbonitrure de bore contient en particulier en % d'atomes de 5 à 85% d'azote, de 5 à 85% de carbone et de 10 à 90% de bore. De préférence, le CBN contient en % d'atomes de 5 à 50% d'azote, de 5 à 85% de carbone et de 10 à 50% de bore.

Pour certaines compositions, le CBN présente des propriétés semi-conductrices.

Lorsque le matériau d'interphase est homogène, celui-ci peut avoir une structure cristalline, amorphe ou intermédiaire. A titre d'exemple, le matériau d'interphase peut avoir les compositions suivantes C₅B₂N ou C₆B₂N (correspondant approximativement à la formule C_{0,64}B_{0,24}N_{0,18}) ou encore la composition C_{0,40}B_{0,33}N_{0,27} ; C_{35,7}B₃₇N_{27,3} ; C₂₄B_{39,4}N_{36,8} ; C_{66,7}B_{23,2}N_{12,4} ; C_{78,6}B_{15,06}N_{6,33} ; C₄₁B_{34,7}N_{24,4} ; C₅₈B₂₉N_{13,7}. Il peut aussi avoir les compositions BCₓ avec 3≤x≤10 et par exemple la composition BC₃.

Lorsque le matériau d'interphase est inhomogène, c'est-à-dire qu'il présente une composition et une structure variant de l'interface fibres-matériau à l'interface matériau-matrice, il est particulièrement intéressant que la composition varie de sorte que la structure évolue graduellement de l'état amorphe à l'état cristallin, de l'interface fibres-matériau à l'interface matériau-matrice.

Cette adaptation graduelle de la structure du matériau d'interphase confère aux matériaux composites d'excellentes propriétés mécaniques, nettement améliorées par rapport à celles des matériaux composites de l'art antérieur. Cette structure évolutive peut être obtenue de façon très simple, dans une même enceinte de dépôt avec les mêmes conditions et les mêmes réactifs, ce qui n'est pas possible avec les matériaux d'interphase connus.

Bien que l'invention s'applique à tous les types de matrices mentionnés précédemment, l'invention est parfaitement bien adaptée aux matrices céramiques et vitrocéramiques.

En particulier, l'invention présente un grand intérêt lorsque la matrice est en nitrure de silicium, en carbure de silicium, en LAS, en MLAS ou encore en CBN ou en AlN. Lorsque la matrice est en CBN, la solution solide utilisée présente une structure cristalline. En particulier, la matrice est en C₅B₂N.

Par ailleurs, bien que l'invention s'applique à tous les types de fibres mentionnés précédemment, l'invention est parfaitement bien adaptée aux fibres de SiC, Si₃N₄, Al₂O₃ , SiO₂, BAS et SiCN.

Pour obtenir de bons résultats, l'épaisseur du matériau d'interphase doit être supérieure à un certain minimum. Au-delà d'une certaine épaisseur, on n'obtient plus un matériau d'interphase mais un matériau composite à matrice mixte.

En général, l'épaisseur de l'interphase de CBN est choisie dans l'intervalle allant de 0,05 à 3 micromètres.

Par ailleurs, l'épaisseur de la couche d'interphase dépend de la nature de la matrice. L'épaisseur de la couche d'interphase diminue lorsque l'allongement à la rupture de la matrice augmente.

En particulier, pour les matrices céramiques, l'épaisseur du matériau d'interphase est choisie de 1 à 1,5 micromètre alors que pour des matrices de verre ou de vitrocéramique, l'épaisseur du matériau d'interphase est choisie dans l'intervalle allant de 0,1 à 0,6 micromètre.

L'invention a aussi pour objet un procédé de fabrication d'un matériau composite à renfort fibreux tel que décrit précédemment.

Selon une première mise en oeuvre, ce procédé comporte les étapes suivantes :
a) - dépôt d'un matériau d'interphase en carbure ou en carbonitrure de bore sur des fibres réfractaires, le carbure ou le carbonitrure de bore ayant une composition en % d'atomes de 0 à 98% d'azote, de 1 à 99% de carbone et de 1 à 99% de bore et une structure lamellaire et/ou amorphe ;
b) - formation d'un renfort fibreux poreux à partir des fibres revêtues du matériau d'interphase, et
c) - densification du renfort poreux obtenu en (b) par formation d'une matrice non métallique.

En particulier le renfort fibreux peut être formé selon la technique de bobinage filamentaire bien connue de l'homme de l'art. Cette étape conduit directement à la mise en forme d'une pièce mécanique.

Selon une seconde mise en oeuvre, le procédé de l'invention comporte les étapes suivantes :
a') - formation du renfort fibreux poreux à partir de fibres réfractaires ;
b') - infiltration de carbonitrure ou de carbure de bore dans le renfort poreux obtenu en a') pour former un matériau d'interphase sur les fibres, le carbonitrure ou le carbure de bore ayant une composition en % d'atomes de 0 à 98% d'azote, de 1 à 99% de carbone et de 1 à 99% de bore, et une structure lamellaire et/ou amorphe ;
c') - densification du renfort poreux obtenu en b') par formation d'une matrice non métallique.

Dans ce cas, le renfort fibreux consiste en un empilement ou à un tissage de fibres puis en une mise en forme du renfort selon la pièce mécanique à réaliser.

La densification peut être réalisée selon toutes les techniques connues de densification et en particulier par voie gazeuse ou liquide, par infiltration de poudres ou par la technique sol-gel.

Le carbonitrure de bore peut être fabriqué à partir de 700°C par la technique de dépôt chimique en phase vapeur (DCPV) en utilisant un mélange réactif de source gazeuse de bore, d'ammoniac et d'hydrocarbure, dilué dans un gaz porteur tel que l'azote ou mieux l'hydrogène, sous une pression de quelques centaines à quelques milliers de Pascals. Les sources gazeuses de bore sont en particulier B₂H₆ ou des halogénures de bore tels que BCl₃ ou BF₃.

Comme hydrocarbure, on peut utiliser un ou plusieurs hydrocarbures plus ou moins substitués ayant de 1 à 5 atomes de carbone. On peut utiliser des hycrocarbures chlorés tels que CHCl₃, CCl₄ ou mieux de l'acétylène.

Les températures et la pression du dépôt en phase vapeur de CBN peuvent être adaptées en fonction de l'hydrocarbure utilisé.

La dilution du mélange réactif par l'hydrogène, bien que non nécessaire, améliore le rendement de l'opération. En outre, l'hydrogène, par rapport à l'azote, change le mécanisme réactionnel mis en jeu en phase gazeuse conduisant à des produits de même composition plus structurés.

Comme on l'a dit précédemment, la composition du CBN peut être modifiée en fonction des propriétés recherchées et en particulier des propriétés de compatibilité avec les matériaux destinés à être en contact avec lui. En fonction de cette composition, la structure ou l'agencement des différents atomes du CBN varie.

Les produits obtenus contiennent le plus souvent un excès de bore par rapport à l'azote. Aussi, il est avantageux d'utiliser un rapport trichlorure de bore/ammoniac supérieur à 1.

Par ailleurs, l'obtention d'une monophase de CBN nécessite d'utiliser une pression partielle d'ammoniac au plus égale à la pression partielle d'hydrocarbure. Lorsque la pression partielle d'ammoniac est supérieure à celle de l'hydrocarbure, on obtient une structure biphasée de BN et de CBN.

Pour obtenir une composition de CBN variant graduellement de l'interface fibres-matériau à l'interface matériau-matrice, il suffit, toute chose égale par ailleurs, de modifier la quantité d'ammoniac introduit dans le mélange réactif.

En particulier, il est possible, dans un même réacteur de dépôt et en gardant les mêmes conditions de dépôt à l'exception de la quantité d'ammoniac, de former une couche de CBN passant progressivement de l'état amorphe à l'état cristallin. L'organisation cristalline du CBN croît lorsque la quantité d'ammoniac décroît dans le réacteur.

Il est aussi possible d'utiliser, comme mélange réactif, une source de bore gazeuse (trichlorure de bore notamment) et des hydrocarbures azotés pour l'apport à la fois d'azote et de carbone. L'hydrocarbure azoté doit être tel que la quantité d'azote dans le CBN soit inférieure à celle du bore. Comme hydrocarbure azoté, on peut citer l'acétonitrile.

L'utilisation d'un mélange réactif de trichlorure de bore et d'hydrocarbure azoté est particulièrement intéressant pour le dépôt d'une couche de CBN, à pression atmosphérique, sur une fibre se déplaçant en continu dans le réacteur de dépôt. Cette technique permet un dépôt homogène de CBN sur toute la longueur de la fibre. L'utilisation d'un hydrocarbure azoté permet d'éviter, dans ce cas particulier, l'utilisation de NH₃ et donc la nucléation du CBN en phase gazeuse. L'hydrocarbure azoté utilisé doit présenter une grande stabilité thermique, les températures de travail étant comprises entre 750 et 1000°C environ.

D'autres caractéristiques et avantages de l'invention ressortiront mieux de la description qui va suivre, donnée à titre illustratif et non limitatif, en référence aux dessins annexés dans lesquels :
- la figure 1 représente schématiquement un matériau composite conforme à l'invention, et
- la figure 2 est un diagramme illustrant les différentes étapes du procédé de fabrication d'une pièce en matériau composite selon l'invention.

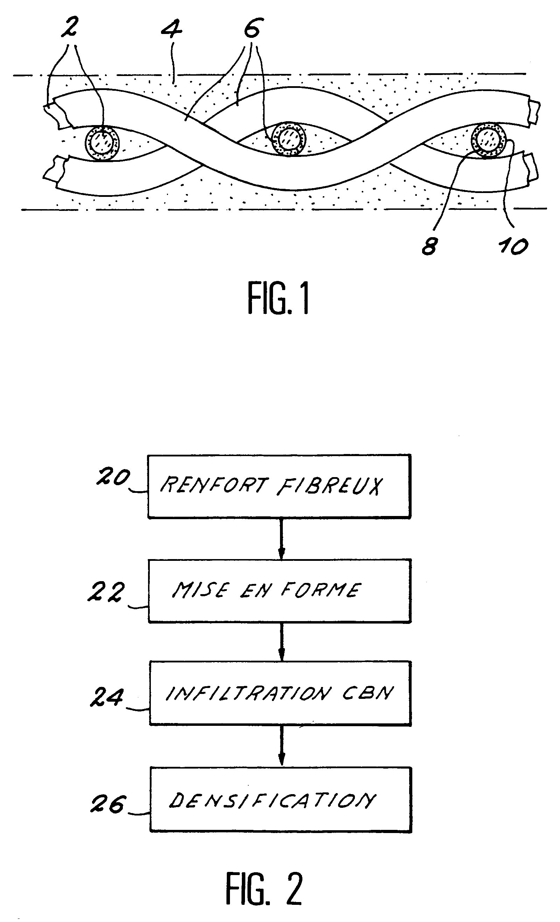

Sur la figure 1, on a représenté schématiquement un matériau composite céramique-céramique comportant des fibres de renforcement 2 en SiC, noyées dans une matrice 4 en nitrure de silicium, en carbonitrure de silicium ou en LAS.

Les fibres ont un diamètre de 10 micromètres environ et sont tissées.

Selon l'invention, chaque fibre 2 est revêtue d'une couche 6 de CBN ayant une épaisseur de 1 à 1,5 micromètre assurant une liaison faible entre la matrice et les fibres et conduisant ainsi à l'obtention d'un matériau composite à structure non fragile.

Le CBN présente une élongation à la rupture supérieure à celle d'une matrice en nitrure de silicium ou de LAS.

Selon l'invention, la couche 6 présente une composition qui varie graduellement de l'interface 8 fibres-CBN à l'interface 10 CBN-matrice ; la quantité de BN décroît graduellement de l'interface 8 à l'interface 10 tandis que la quantité en carbone croît graduellement de l'interface 8 à l'interface 10.

Selon l'invention, la composition est telle que la structure évolue de l'état amorphe à l'état critallin de l'interface 8 à l'interface 10. En particulier, le CBN à l'interface 8 présente la composition C_{0,40}B_{0,33}N_{0,27} et le CBN à l'interface 10 présente la composition C₅B₂N.

On décrit ci-après, en référence à la figure 2, un exemple de fabrication d'une pièce en matériau composite selon l'invention.

La première étape du procédé, comme symbolisée par le bloc 20 de la figure 2, consiste à former une structure poreuse déformable en SiC, en tissant des fibres 2 de SiC selon trois directions orthogonales, de façon connue. Les fibres sont des fibres SiC Nicalon^{(R)} vendues par la société Nippon Carbon.

La seconde étape du procédé, schématisée par le bloc 22, consiste à mettre en forme le renfort fibreux de façon à ce qu'il constitue la préforme de la pièce en matériau composite à réaliser.

On effectue alors une infiltration de CBN, symbolisée par le bloc 24, dans la préforme de façon à former la couche d'interphase 6 de CBN sur les fibres. Le CBN est déposé par DCPV en utilisant un mélange réactif de BCl₃, C₂H₂, NH₃, dilué dans de l'hydrogène.

Les conditions opératoires sont les suivantes :
- température de dépôt au moins égale à 1000°C et typiquement comprise entre 1000 et 1100°C,
- pression totale de 15 hPa,
- débit de C₂H₂ de 0,6 litre par heure,
- débit de BCl₃ de 1 litre par heure,
- débit de NH₃ inférieur à 0,6 litre par heure,
- taux de dilution des gaz réactifs dans l'hydrogène supérieur à 10,
- vitesse des gaz de 1 mètre par seconde.

La cinétique de croissance est une fonction proportionnelle au débit de NH₃ et proportionnelle à la température et est inversement proportionnelle à la pression. La cinétique de croissance notée r, satisfait à l'équation 0,5≤r≤5 micromètres/heure.

De plus, la quantité de carbone dans le CBN croît avec la température de dépôt.

Le débit de NH₃ dirige la composition du produit.

Lorsque la pression partielle de NH₃ est proche de la pression partielle de C₂H₂, le CBN est amorphe alors que quand la pression partielle du NH₃ est cinq fois plus faible que la pression partielle de C₂H₂, le CBN est cristallin.

En diminuant progressivement le débit de NH₃ dans le réacteur de dépôt, on obtient une couche 6 de CBN dont la composition en carbone croît de l'interface 8 à l'interface 10 et dont la structure évolue graduellement de l'état amorphe à l'état cristallin.

L'étape suivante du procédé, représentée par le bloc 26, se rapporte à la densification de la structure fibreuse infiltrée par le CBN, en vue de former la matrice céramique.

Selon un premier exemple, la matrice est une matrice de Si₃N₄ ; elle est réalisée par dépôt chimique en phase vapeur d'un mélange gazeux contenant de l'ammoniac et un silane chloré tel que SiCl₄ ou SiHCl₃ dans un rapport (NH₃)/(SiCl₄ ou SiHCl₃)=4/3. Ce dépôt est réalisé vers 1050°C sous 6 hPa.

Selon un second exemple, la matrice est une matrice de LAS ; elle est formée par la technique sol-gel. A cet effet, un sol contenant 90,13g de suspension aqueuse de silice (LUDOX AS 40 de la société Du Pont de Nemours), 20,68g de nitrate de lithium, 112,54g de nitrate d'aluminium et 13,17g de tétraborate d'ammonium a été préparé dans 240cm³ d'eau. Le pH du sol est ajusté à la valeur de 1.

La structure fibreuse infiltrée de CBN est alors imprégnée par le sol puis séchée à température ambiante. Ce cycle d'imprégnation-séchage est reproduit sept fois. Le préimprégné est ensuite déshydraté à 100°C pendant 1 heure. On effectue alors une étape de compression à chaud avec un palier à 900°C durant 30 minutes. Une pression uniaxiale de 12,5 Mpa est appliquée progressivement à partir de 500°C jusqu'à la fin de la compression à chaud. Lors du refroidissement, la pression est relâchée.

La température maximale d'utilisation de ce matériau composite est de 830°C. Dans le cas, où l'on traite le matériau sous une atmosphère d'ammoniac, durant 2 heures à une température de 800°C, on observe que la température maximale d'utilisation est portée à 950°C.

Dans les mêmes conditions que celles décrites ci-dessus, en référence à la figure 2, il est possible de déposer le CBN directement sur les fibres, avant de les assembler pour former la structure de renfort poreuse. Après mise en forme de la structure poreuse, celle-ci est densifiée.

## Revendications

1. Matériau composite à renfort fibreux, comportant des fibres réfractaires (2) noyées dans une matrice non métallique (4), et un matériau d'interphase (6) interposé entre les fibres et la matrice, caractérisé en ce que le matériau d'interphase est du carbure ou du carbonitrure de bore à structure lamellaire et/ou amorphe, contenant en % d'atomes, de 0 à 98% d'azote, de 1 à 99% de carbone et de 1 à 99% de bore.

2. Matériau composite selon la revendication 1, caractérisé en ce que le carbonitrure de bore contient en % d'atomes de 5 à 50% d'azote, de 5 à 85% de carbone et de 10 à 50% de bore.

3. Matériau composite selon la revendication 1 ou 2, caractérisé en ce que le carbonitrure de bore présente la formule C₅B₂N.

4. Matériau composite selon la revendication 1, caractérisé en ce que le carbure de bore présente la formule BCₓ avec 3≤x≤10.

5. Matériau composite selon la revendication 1 ou 2, caractérisé en ce que la composition du matériau d'interphase varie de l'interface (8) fibres-matériau à l'interface (10) matériau-matrice.

6. Matériau composite selon la revendication 1 ou 2, caractérisé en ce que le matériau d'interphase présente une structure évolutive passant graduellement de l'état amorphe à l'état lamellaire de l'interface (8) fibres-matériau à l'interface (10) matériau-matrice.

7. Matériau composite à renfort fibreux comportant des fibres réfractaires (2) noyées dans une matrice (4) et un matériau d'interphase (6) interposé entre les fibres et la matrice, caractérisé en ce que le matériau d'interphase est du carbonitrure de bore dont la composition varie de l'interface (8) fibres-matériau à l'interface (10) matériau-matrice.

8. Matériau composite selon la revendication 7, caractérisé en ce que le matériau d' interphase (6) présente une structure évolutive passant graduellement de l'état amorphe à l'état cristallin lamellaire de l'interface (8) fibres-matériau à l'interface (10) matériau-matrice.

9. Matériau composite selon l'une quelconque des revendications 1 à 8, caractérisé en ce que le matériau d'interphase (6) présente une épaisseur allant de 0,05 à 3 micromètres.

10. Matériau composite selon l'une quelconque des revendications 1 à 9, caractérisé en ce que la matrice (4) est une matrice céramique, vitrocéramique ou de verre.

11. Matériau composite selon l'une quelconque des revendications 1 à 10, caractérisé en ce que la matrice (4) est du carbonitrure de bore à l'état cristallin.

12. Matériau composite selon l'une quelconque des revendications 1 à 10, caractérisé en ce que la matrice (4) est en Si₃N₄, SiC, aluminosilicate de lithium (LAS), aluminosilicate de lithium et de magnésium (MLAS) ou AlN.

13. Matériau composite selon l'une quelconque des revendications 1 à 12, caractérisé en ce que les fibres (2) sont des fibres non métalliques.

14. Matériau composite selon l'une quelconque des revendications 1 à 13, caractérisé en ce que les fibres (2) sont en SiC, Si₃N₄,Al₂O₃, SiO₂, aluminosilicate de bore (BAS) ou SiCN.

15. Procédé de fabrication d'un matériau composite à renfort fibreux, comportant les étapes suivantes :
a) - dépôt d'un matériau d'interphase (6) en carbure ou en carbonitrure de bore sur des fibres réfractaires (2), le carbure ou le carbonitrure de bore ayant une composition en % d'atomes de 0 à 98% d'azote, de 1 à 99% de carbone et de 1 à 99% de bore et une Structure lamellaire et/ou amorphe ;
b) - formation d'un renfort fibreux poreux à partir des fibres revêtues du matériau d'interphase, et
c) - densification (26) du renfort poreux obtenu en (b) par formation d'une matrice non métallique
(4).

16. Procédé de fabrication d'un matériau composite à renfort fibreux, comportant les étapes suivantes :
a') - formation (20) d'un renfort fibreux poreux à partir de fibres réfractaires ;
b') - infiltration (24) de carbonitrure ou de carbure de bore dans le renfort poreux obtenu en a') pour former un matériau d'interphase (6) sur les fibres, le carbonitrure ou le carbure de bore ayant une composition en % d'atomes de 0 à 98% d'azote, de 1 à 99% de carbone et de 1 à 99% de bore, et une structure lamellaire et/ou amorphe ; et
c') - densification (26) du renfort poreux obtenu en b') par formation d'une matrice non métallique (4).

17. Procédé selon la revendication 15 ou 16, caractérisé en ce que l'on forme le carbonitrure de bore par dépôt chimique en phase vapeur en utilisant un mélange réactif de source gazeuse de bore et d'hydrocarbure azoté, dilué dans un gaz porteur.

18. Procédé selon la revendication 15 ou 16, caractérisé en ce que l'on forme le carbonitrure de bore par dépôt chimique en phase vapeur en utilisant un mélange réactif de source gazeuse de bore, d'ammoniac et d'hydrocarbure, dilué dans un gaz porteur.

19. Procédé selon la revendication 17 ou 18, caractérisé en ce que la source gazeuse de bore est du trichlorure de bore.

20. Procédé selon la revendication 19, caractérisé en ce que le rapport trichlorure de bore/ammoniac est >1.

21. Procédé selon l'une quelconque des revendications 18 à 20, caractérisé en ce que la pression partielle d'ammoniac est au plus égale à la pression partielle d'hydrocarbure.

22. Procédé selon l'une quelconque des revendications 18 à 21, caractérisé en ce que l'hydrocarbure est l'acétylène.

23. Procédé selon l'une quelconque des revendications 17 à 22, caractérisé en ce que le taux de dilution du mélange réactif dans le gaz porteur est supérieur à 10.

24. Procédé selon l'une quelconque des revendications 18 à 23, caractérisé en ce que l'on fait varier graduellement la quantité d'ammoniac dans le mélange réactif.

25. Procédé selon l'une quelconque des revendications 18 à 23, caractérisé en ce que l'on diminue graduellement la quantité d'ammoniac dans le mélange réactif.

## Claims

1. Composite material having a fibrous reinforcement, incorporating refractory fibres (2) embedded in a nonmetallic matrix (4) and an interphase material (6) interposed between the fibres and the matrix, characterized in that the interphase material is boron carbide or carbonitride with a lamellar and/or amorphous structure, containing in atomic %, 0 to 98% nitrogen, 1 to 99% carbon and 1 to 99% boron.

2. Composite material according to claim 1, characterized in that the boron carbonitride contains, in atomic %, 5 to 50% nitrogen, 5 to 85% carbon and 10 to 50% boron.

3. Composite material according to claim 1, characterized in that the boron carbonitride is of formula C₅B₂N.

4. Composite material according to claim 1, characterized in that the boron carbide is of formula BCₓ with 3≤x≤10.

5. Composite material according to claim 1 or 2, characterized in that the composition of the interphase material varies from the fibre-material interface (8) to the material-matrix interface (10).

6. Composite material according to claim 1 or 2, characterized in that the interphase material has an evolutive structure passing gradually from the amorphous state to the lamellar state from the fibre-material interface (8) to the material-matrix interface (10).

7. Composite material with a fibrous reinforcement incorporating refractory fibres (2) embedded in a matrix (4) and an interphase material (6) interposed between the fibres and the matrix, characterized in that the interphase material is boron carbonitride, whose composition varies from the fibre-material interface (8) to the material-matrix interface (10).

8. Composite material according to claim 7, characterized in that the interphase material (6) has an evolutive structure passing gradually from the amorphous state to the lamellar crystalline state from the fibre-material interface (8) to the material-matrix interface (10).

9. Composite material according to claims 1 or 8, characterized in that the interphase material (6) has a thickness between 0.05 and 3 micrometers.

10. Composite material according to claims 1 or 9, characterized in that the matrix (4) is a ceramic, vitroceramic or glass matrix.

11. Composite material according to claims 1 or 10, characterized in that the matrix (4) is boron carbonitride in the crystalline state.

12. Composite material according to claims 1 or 10, characterized in that the matrix (4) is of Si₃N₄, SiC, lithium aluminosilicate (LAS), lithium and magnesium aluminosilicate (MLAS) or AlN.

13. Composite material according to claims 1 or 12, characterized in that the fibres (2) are nonmetallic fibres.

14. Composite material according to claims 1 or 13, characterized in that the fibres (2) are of SiC, Si₃N₄, Al₂O₃, SiO₂, boron aluminosilicate (BAS) or SiCN.

15. Process for producing a composite material with a fibrous reinforcement having the following stages:
a) deposition of a boron carbide or carbonitride interphase material (6) on the refractory fibres (2), the boron carbide or carbonitride having an atomic % composition of 0 to 98% nitrogen, 1 to 99% carbon and 1 to 99% boron and a lamellar and/or amorphous structure,
b) the formation of a porous fibrous reinforcement from the fibres coated with the interphase material, and
c) densification (26) of the porous reinforcement obtained in b) by forming a nonmetallic matrix (4).

16. Process for producing a composite material with a fibrous reinforcement having the following stages:
a') formation (20) of a porous fibrous reinforcement from refractory fibres,
b') infiltration (24) of the boron carbide or carbonitride into the porous reinforcement obtained in a') for forming an interphase material (6) on the fibres, the boron carbide or carbonitride having an atomic % composition of 0 to 98% nitrogen, 1 to 99% carbon and 1 to 99% boron and a lamellar and/or amorphous structure and
c') densification (26) of the porous reinforcement obtained in b') by forming a nonmetallic matrix (4).

17. Process according to claims 15 or 16, characterized in that the boron carbonitride is formed by chemical vapour deposition using a reactive gaseous source mixture of boron and nitrogen hydrocarbon diluted in a carrier gas.

18. Process according to claims 15 or 16, characterized in that the boron carbonitride is formed by chemical vapour deposition using a reactive gaseous source mixture of boron, ammonia and hydrocarbon diluted in a carrier gas.

19. Process according to claim 17 or 18, characterized in that the gaseous boron source is boron trichloride.

20. Process according to claim 19, characterized in that the boron trichloride/ammonia ratio is > 1.

21. Process according to any one of the claims 18 to 20, characterized in that the partial ammonia pressure is at the most equal to the partial hydrocarbon pressure.

22. Process according to any one of the claims 18 to 21, characterized in that the hydrocarbon is acetylene.

23. Process according to any one of the claims 17 to 22, characterized in that the dilution rate of the reactive mixture in the carrier gas exceeds 10.

24. Process according to any one of the claims 18 to 23, characterized in that there is a gradual variation of the ammonia quantity in the reactive mixture.

25. Process according to any one of the claims 18 to 23, characterized in that there is a gradual decrease of the ammonia quantity in the reactive mixture.

## Patentansprüche

1. Verbundmaterial mit Faserarmierung, bestehend aus feuerfesten Fasern (2), welche in eine nichtmetallische Matrix (4) eingebettet sind, und einem zwischen die Fasern und die Matrix eingebrachten Zwischenphasenmaterial (6), dadurch gekennzeichnet, dass das Zwischenphasenmaterial aus Borcarbid oder Borcarbonitrid mit lamellarer und/oder amorpher Struktur besteht, und (in Atomprozent) 0 bis 98% Stickstoff, 1 bis 99% Kohlenstoff und 1 bis 99% Bor enthält.

2. Verbundmaterial nach Anspruch 1, dadurch gekennzeichnet, dass das Borcarbonitrid (in Atomprozent) 5 bis 50% Stickstoff, 5 bis 85% Kohlenstoff und 10 bis 50% Bor enthält.

3. Verbundmaterial nach Anspruch 1 oder 2, dadurch gekennzeichnet, dass das Borcarbonitrid die Formel C₅B₂N zeigt.

4. Verbundmaterial nach Anspruch 1, dadurch gekennzeichnet, dass das Borcarbid die Formel BCₓ mit 3≤x≤10 zeigt.

5. Verbundmaterial nach Anspruch 1 oder 2, dadurch gekennzeichnet, dass die Zusammensetzung des Zwischenphasenmaterialss von der Grenzfläche (8) Fasern/Material bis zur Grenzfläche (10) Material/Matrix variiert.

6. Verbundmaterial nach Anspruch 1 oder 2, dadurch gekennzeichnet, dass das Zwischenphasenmaterial eine sich wandelnde Struktur zeigt, die vom amorphen Zustand stufenweise in den lamellaren Zustand von der Grenzfläche (8) Fasern/Material bis zur Grenzfläche(10) Material/Matrix übergeht.

7. Verbundmaterial mit Faserarmierung, bestehend aus feuerfesten Fasern (2), welche in eine Matrix (4) eingebettet sind, und einem zwischen die Fasern und die Matrix eingebrachten Zwischenphasenmaterial (6), dadurch gekennzeichnet, dass das Zwischenphasenmaterial aus Borcarbonitrid besteht, dessen Zusammensetzung von der Grenzfläche (8) Fasern/Material bis zur Grenzfläche (10) Material/Matrix variiert.

8. Verbundmaterial nach Anspruch 7, dadurch gekennzeichnet, dass das Zwischenphasenmaterial (6) eine sich wandelnde Struktur zeigt, die vom amorphen Zustand stufenweise in den kristallinen lamellaren Zustand von der Grenzfläche (8) Fasern/Material bis zur Grenzfläche(10) Material/Matrix übergeht.

9. Verbundmaterial nach einem der Ansprüche 1 bis 8, dadurch gekennzeichnet, dass das Zwischenphasenmaterial (6) eine Dicke von 0,05 bis 3 Mikrometer aufweist.

10. Verbundmaterial nach einem der Ansprüche 1 bis 9 dadurch gekennzeichnet, dass die Matrix (4) eine keramische, glaskeramische oder Glas-Matrix ist.

11. Verbundmaterial nach einem der Ansprüche 1 bis 10, dadurch gekennzeichnet, dass die Matrix (4) aus Borcarbonitrid im kristallinen Zustand besteht.

12. Verbundmaterial nach einem der Ansprüche 1 bis 10 , dadurch gekennzeichnet, dass die Matrix (4) aus Si₃N₄, SiC, Lithiumalumosilicat (LAS), Lithiummagnesiumalumosilicat (MLAS) oder AlN besteht.

13. Verbundmaterial nach einem der Ansprüche 1 bis 12, dadurch gekennzeichnet, dass die Fasern (2) nichtmetallische Fasern sind.

14. Verbundmaterial nach einem der Ansprüche 1 bis 13, dadurch gekennzeichnet, dass die Fasern (2) aus SiC, Si₃N₄, Al₂O₃, SiO₂, Boralumosilicat (BAS) oder SiCN bestehen.

15. Herstellungsverfahren für ein Verbundmaterial mit Faserarmierung, bestehend aus den folgenden Abschnitten:
a) - Aufbringen eines Zwischenphasenmaterials (6) aus Borcarbid oder Borcarbonitrid auf feuerfeste Fasern (2), wobei das Borcarbid oder Borcarbonitrid eine Zusammensetzung (in Atomprozent) von 0 bis 98% Stickstoff, von 1 bis 99% Kohlenstoff und von 1 bis 99% Bor und lamellare und/oder amorphe Struktur hat;
b) - Bildung einer porösen Faserarmierung ausgehend von den mit Zwischenphasenmaterial überzogenen Fasern, und
c) - Verdichtung (26) der in (b) erhaltenen porösen Armierung durch Bildung einer nichtmetallischen Matrix (4).

16. Herstellungsverfahren für ein Verbundmaterial mit Faserarmierung, bestehend aus den folgenden Abschnitten:
a') - Bildung (20) einer porösen Faserarmierung ausgehend von feuerfesten Fasern;
b') - Einbringen (24) von Borcarbonitrid oder Borcarbid in die bei a') erhaltene poröse Armierung zur Bildung eines Zwischenphasenmaterials (6) auf den Fasern, wobei das Borcarbonitrid oder Borcarbid eine Zusammensetzung (in Atomprozent) von 0 bis 98% Stickstoff, von 1 bis 99% Kohlenstoff und von 1 bis 99% Bor und lamellare und/oder amorphe Struktur hat; und
c') - Verdichtung (26) der in b') erhaltenen porösen Armierung durch Bildung einer nichtmetallischen Matrix (4).

17. Verfahren nach Anspruch 15 oder 16, dadurch gekennzeichnet, dass das Borcarbonitrid durch chemische Kondensation aus der Dampfphase unter Verwendung eines Reaktionsgemischs aus gasförmigen Ausgangsstoffen von Bor und stickstoffhaltigem Kohlenwasserstoff, verdünnt in einem Trägergas, gebildet wird.

18. Verfahren nach Anspruch 15 oder 16, dadurch gekennzeichnet, dass das Borcarbonitrid durch chemische Kondensation aus der Dampfphase unter Verwendung eines Reaktionsgemischs aus gasförmigen Ausgangsstoffen von Bor gebildet wird..

19. Verfahren nach Anspruch 17 oder 18, dadurch gekennzeichnet, dass der gasförmige Ausgangsstoff von Bor Bortrichlorid ist.

20. Verfahren nach Anspruch 19, dadurch gekennzeichnet, dass das Verhältnis Bortrichlorid/Ammoniak >1 ist.

21. Verfahren nach einem der Ansprüche 18 bis 20, dadurch gekennzeichnet, dass der Partialdruck von Ammoniak höchstens gleich dem Partialdruck des Kohlenwasserstoffs ist.

22. Verfahren nach einem der Ansprüche 18 bis 21, dadurch gekennzeichnet, dass der Kohlenwasserstoff Acetylen ist.

23. Verfahren nach einem der Ansprüche 17 bis 22, dadurch gekennzeichnet, dass der Verdünnungsgrad des Reaktionsgemischs im Trägergas größer als 10 ist.

24. Verfahren nach einem der Ansprüche 18 bis 23, dadurch gekennzeichnet, dass die Ammoniakmenge im Reaktionsgemisch stufenweise verändert wird.

25. Verfahren nach einem der Ansprüche 18 bis 23, dadurch gekennzeichnet, dass die Ammoniakmenge im Reaktionsgemisch stufenweise verringert wird.
